(19) Europäisches Patentamt / European Patent Office / Office européen des brevets

(11) **EP 2 439 662 A1**

(12) **EUROPEAN PATENT APPLICATION**

(43) Date of publication:
**11.04.2012 Bulletin 2012/15**

(51) Int Cl.:
***G06F 17/50*** *(2006.01)*

(21) Application number: **10178381.9**

(22) Date of filing: **22.09.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Siemens Aktiengesellschaft**
**80333 München (DE)**

(72) Inventors:
 • **Barti, Endre, Dr.**
  **80689 München (DE)**
 • **Wever, Utz, Dr.**
  **81539 München (DE)**

Remarks:
Amended claims in accordance with Rule 137(2) EPC.

(54) **An analysis method, apparatus and software for a system with frequency dependent materials**

(57)  The present invention relates to an analysis method, apparatus and computer software for a system comprising frequency dependent materials practiced via an analysis apparatus. In accordance to the present invention frequency dependent information regarding a plurality of variables characteristic for the frequency dependant material is imported, a characteristic relationship for the frequency where a system response has a peak value is providing, wherein a value of a frequency provided into the analysis apparatus is equal to a frequency where the system response has a peak, the characteristic relationship is solved by applying an iteration sequence, and a plurality of frequency values are obtained that define the system response peaks for the frequency dependant material, wherein the response is one of an amplitude of the oscillation, and stress.

## FIG 1

EP 2 439 662 A1

**Description**

FIELD OF THE INVENTION

The present invention relates generally to the field of materials analysis and more particularly to an analysis method, apparatus and computer software for studying the behavior of systems comprising frequency dependent materials, the method and computer software being practiced via an analysis apparatus.

BACKGROUND OF THE INVENTION

Today's modern devices, for example in the field of medical devices, make use to a large degree of polymer materials, and sometimes are built in their entirety of polymer materials.

Polymers are used in the manufacture of medical devices, technical devices, and many others. During their development phase, said devices go through multiple testing phases during which, among others, their behavior is reviewed versus the applied frequency.

Traditionally, following the design phase of a technical device, a prototype of the medical device is built, that is tested, and possibly many other prototypes of the device need to be built and tested till the design phase of the technical device is completed. Therefore the testing phase involves use of time and materials, especially if various defects are detected and more new prototypes need to be build for continued testing. Further, should a defect be detected upon testing the ready prototype, the defect is sometimes corrected by changing the materials employed for building the device or by changing the geometry of the parts. This in turn leads to more testing cycles that need to be performed, upon new prototypes that need to be continually manufactured.

Other examples apart from medical devices that comprise elastomers that suffer from the same problems are cooling tubes employed in car engines.

Therefore, a need exists for reducing the amount of time necessary, and resources employed during the testing of devices comprising elastomers and polymers.

Usually the amount of time and resources necessary has been proposed to be reduced by performing exclusively computer simulation of the devices to be built and attempting to develop and test all the constructional details of the device intended to be realized via computer simulation. As such the need for building and testing actual prototypes is eliminated.

The virtual testing of the devices posses a plurality of other problems such as is very difficult to accurately reproduce the behavior of materials that are frequency dependent, such as polymers and rubbers, to reproduce the behavior of technical assemblies, to reproduce the behavior of contact regions between components, especially if the device is intended to be realized via a material that has a non linear behavior, such as rubber and polymers.

Regarding these contact regions and materials a modal, or a harmonic analysis is not applicable. Currently is only possible to make, via commercial simulation tools, a linear analysis of the structural mechanics for materials. Said simulation tools do not work for materials that are frequency dependant. Further, the simulation tools currently available do not allow simulating the dynamical behavior of materials that are frequency dependant or the dynamical behavior of assemblies comprising frequency dependant materials, especially in a frequency range from 1 to 30,000 Hz.

Therefore, a need still exists for a simulation tool capable of performing accurate simulation in the frequency domain of the behavior of materials that are frequency dependant. Further, a need still exists for an apparatus that permits the dynamical simulation of the behavior of materials that are frequency dependant.

SHORT SUMMARY OF THE INVENTION

An analysis method for a system comprising frequency dependent materials, practiced by an analysis apparatus is proposed by the present invention. The method comprises at least importing a frequency dependent information regarding a plurality of variables characteristic for the frequency dependant material, providing a characteristic relationship for the frequency where a system response has a peak value, wherein a value of a frequency provided into the analysis apparatus is equal to a frequency where the system response has a peak, solving the characteristic relationship by applying an iteration sequence, and obtaining a plurality of frequency values that define the system response peaks for the frequency dependant material, wherein response is one of an amplitude of the oscillation, stress or other response.

According to another aspect of the present invention an analysis apparatus for studying the behavior of a system comprising frequency dependant materials is proposed. The apparatus comprises means for importing a frequency dependent information regarding a plurality of variables characteristic for the frequency dependant material, means for providing a characteristic relationship for the frequency where the system response has a peak value, wherein a value of a frequency provided into the analysis apparatus is equal to a frequency where the system response has a peak, means for solving the characteristic relationship by applying an iteration sequence, and means for obtaining a plurality of frequency values that define the system response peaks for the frequency dependant material, wherein the response is one of amplitude of the oscillation, stress or other response.

According to yet another aspect of the present invention an analysis software means for a system comprising frequency dependent material residing into an analysis apparatus are proposed. The proposed software enables importing a frequency dependent information regarding a plurality of variables characteristic for the frequency dependant material, providing a characteristic relationship for the frequency where a system response has a peak value, wherein a value of a frequency provided into said analysis apparatus is equal to a frequency where the system response has a peak, solving the characteristic relationship by applying an iteration sequence, and obtaining a plurality of frequency values that define said system response peaks for the frequency dependant material, wherein the response is one of an amplitude of the oscillation, stress or other response.

Particularly advantageous embodiments and features of the invention are given by the dependent claims, as revealed in the following description.

The analysis method for a system comprising frequency dependent materials of the present invention is applied for frequency dependant materials such as elastomeric compounds, polymers and rubbers.

For the analysis method for a system comprising frequency dependent materials of the present invention the plurality of variables characteristic for the frequency dependent materials comprises at least one of Young's modulus (E), Poisson's ratio, and loss factor or damping coefficient.

For the analysis method for a system comprising frequency dependent materials of the present invention the plurality of variables characteristic for the frequency dependent materials damping (C) and stiffness (K) have a matrix representation.

In the method proposed by the present invention the plurality of variables characteristic for the frequency dependant material are imported from commercially available tables, and databases listing materials properties. For the analysis method for a system comprising frequency dependent materials of the present the peak value of the system response is defined by an eigenvalue with a real and an imaginary part, and the eigenvalue is frequency dependent.

For the analysis method for a system comprising frequency dependent materials of the present invention the matrices C, and K are frequency dependent. For the analysis method for a system comprising frequency dependent materials of the present invention said characteristic relationship for a system response peak value is $f_{(\omega)}=I_m(\lambda(\omega) - 1/2n\omega = 0$, where $\lambda(\omega)$ is the eigenvalue of the linear frequency analysis.

For the analysis method for a system comprising frequency dependent materials of the present invention the iteration is one of a Gauss-Seidel iteration and a Newton's method. For the analysis method for a system comprising frequency dependent materials of the present invention the method is employed for simulating the dynamical behavior of parts and assemblies containing frequency dependent materials.

The method of the present invention permits determining the desired frequency eigenvalues via a mathematical equation which is solved efficiently, in contrast with the method know from the art that assume that accurate scanning of the frequency range was necessary in order to obtain desired frequency eigenvalues and the corresponding mode shapes. This approach used in the art is extremely expensive in terms of computation time. As mentioned above the method of the present invention determines the desired eigenfrequency by a mathematical equation that may be solved efficiently. Besides the enormous computational time and capacity savings the new method delivers accurate results, because the desired value is determined as a solution to an equation.

Regarding the apparatus of the present invention, the means for storing the information are a memory, and the memory stores an iteration sequence. The means for stating a characteristic relationship for a peak value of a frequency are software storing and running means.

Regarding the apparatus of the present invention the means for solving the characteristic relationship by applying an iteration sequence are a processor, the mean for obtaining a plurality of frequency values comprise among others display means, and the display means display the data as one of a graph and a collection of values.

BRIEF DESCRIPTION OF THE DRAWINGS

Other objects and features of the present invention will become apparent from the following detailed descriptions considered in conjunction with the accompanying drawings. It is to be understood, however, that the drawings are designed solely for the purposes of illustration and not as a definition of the limits of the invention.

Fig. 1. illustrates the dependency of the Young's module with the frequency in the case of polymers;

Fig. 2 is a representation of how the material oscillates with the frequency obtained applying the finite method of analysis, and

Fig. 3 is a representation of a flow chart of the method of the present invention.

In the drawings, like reference numbers refer to like objects throughout. Objects in the diagrams are not necessarily drawn to scale.

DETAILED DESCRIPTION OF THE INVENTION

The materials such as polymers and rubbers are special materials since their characteristics are not constant but are frequency dependent. Examples of such variables are the Young's modulus (E), the Poisson's ratio and the loss factor.

While studying the behaviors of devices constructed from polymers and rubbers the oscillation, movement, vibration of the materials is studied. In the art are known attempts to study said behaviors via an equation such as:

$$M\ddot{u}(t) + C(f)\dot{u}(t) + K(f)u(t) = 0 \qquad (1)$$

Where :

M is the mass matrix;
$\ddot{u}(t)$ is the second derivative, acceleration, indicative of the displacement of the material or indicated how the material oscillates/moves;
C(f) is the damping matrix;
$\dot{u}(t)$ is the first derivative, velocity;
K(f) is the stiffness matrix;
u(t) is the function describing the displacement,
t is time, and f is frequency.

In the art the above equation is attempted to be solved in the time domain. Obtaining a solution to the above equation in the time domain is a lengthy and a time consuming process. Further, the solution process consumes a large computing power.

In the art the equation is also attempted to be solved in the frequency domain, such as for application where the equation is intended to be used to simulate the frequency dependent behavior of devices made of polymers. In the art the above equation is attempted to be solved by considering that the non-linear dependency of Young's module and the damping with respect to frequency are given by discrete points.

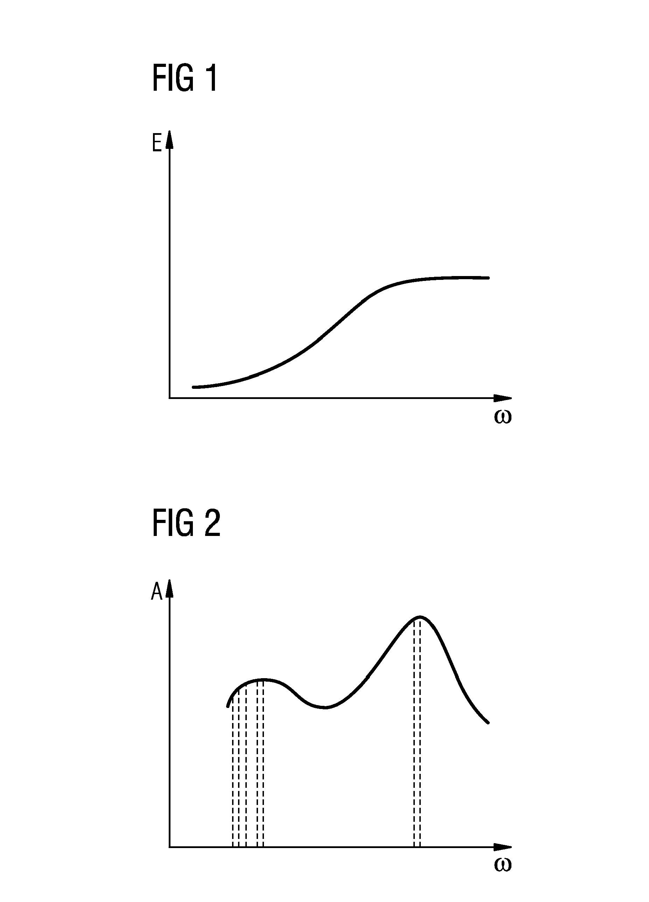

While referring to the illustration of Fig. 1, figure 1 represents the dependency of the Young's modulus with the frequency in the case of polymers.

Referring now to the illustration of Fig. 2, figure 2 is a representation of the amplitude versus frequency for a material whose behavior is frequency dependent. In order to simulate the behavior of the frequency dependent material the curve has been obtained by choosing a plurality of many values in the frequency domain and the corresponding amplitude is computed on the curve. Some of the obtained points on the curve correspond to frequency peaks that are attempted to be calculated to fully characterize the behavior of the frequency dependent material. Such a process of identification of the frequency peaks is time and resources intensive, and does not lead to sufficiently accurate results.

Referring back to the attempt to solve the above equation in the frequency domain, similarly as above, a plurality of discrete values are given at least for the Young's modulus and the damping coefficient, $(f_i, E(f_i), C(f_i))$, i=1, ..., n.

Following the choice of the plurality of discrete values the equation is attempted two be solved in the frequency domain

$$M\ddot{u}(t) + C(f)\dot{u}(t) + K(f)u(t) = \cos(2\pi f_i t), \quad i=1, \dots n. \qquad (2)$$

When solved in the frequency domain, for applications where it is intended to simulate the frequency dependent behavior of devices made of polymers and rubbers the right side of the equation is artificially excited to $\cos(2\pi f_i t)$. The solution to the equation is expected to indicate a curve behavior.

Similarly to how it is represented in Fig. 2, the solutions to with the highest amplitude denote the peak values. But in order to obtain a good approximation for the peak values of the frequencies, the equation must be solved several hundred of times. Such solution algorithms are usually automated, and are exemplarily implemented in finite element methods ANSYS or FemLab, which are the most frequently used software for structural mechanics simulation. Further, in order to provide accurate results a long time and large computing power is needed.

Therefore, a need still exists for a simulation tool capable of performing accurate simulation of the behavior of materials that are frequency dependant. Further, a need still exists for a tool that permits the dynamical simulation of the behavior of materials that are frequency dependant.

The present invention proposes a solution to the above referenced problem for example by proposing a simulation tool that employs an analysis method for systems comprising frequency dependent materials comprising importing a frequency dependence information regarding a plurality of variables characteristic for the frequency dependant material, stating a characteristic relationship for a peak value of a frequency, the characteristic relationship taking into account at least one of the plurality of variables characteristic for the frequency dependant material, assuming that a value of a frequency provided to the analysis apparatus is equal with one of a plurality of peak frequency values, solving the characteristic relationship by applying an iteration sequence, and obtaining a plurality of frequency values that define the plurality of frequency peaks for the frequency dependant material studied.

Specifically, the present invention considers solving the specified equation via an iteration method directly for the autonomous case. The key observation is that the input frequency for the computation of the Young's modulus and the damping matrix must be equal with the peak frequency of the system.

Therefore it is stated a characteristic relationship for an eigenvalue of a frequency, the characteristic relationship taking into account at least one of the plurality of variables characteristic for the frequency dependant material:

$$f_{(\omega)} = I_m(\lambda(\omega)) - 1/2\pi\omega = 0 \qquad (3)$$

where $I_m(\lambda(\omega))$ stands for the imaginary part function of the eigenvalue for the autonomous system of the equation 1, which defines the frequency, and $1/2n\omega$ stands for the input frequency for the frequency dependent material properties, wherein the eigenvalue defined the frequency of the system.

In order to solve equation 3, solving the characteristic relationship at least two iteration methods may be applied: the Gauss-Seidel type iteration and the Newton method.

Referring back to equation 1, that is employed to be solve in frequency values, the frequency dependence information regarding a plurality of variables characteristic for the frequency dependant materials comprised in equation 1 are imported from available sources. Said sources may be commercially available tables and databases.

It is assumed that a value of a frequency provided to the analysis apparatus is equal with one of a plurality of peak frequency values.

The Gauss-Seidel type iteration starts with an initial value and evaluates the system. The solution is taken as the next value and the system is evaluated again. This process is repeated and continued to be performed till convergence.

The Gauss-Seidel type iteration has the advantage that a FEM-software can be used as a black box.

The Newton method is an iteration that starts with an initial value. Because the Newton iteration is an iteration that also uses gradient information, the convergence rate is larger, when compared to the Gauss-Seidel type iteration, and as such requires less system evaluations.

With the perturbation theory for eigenvalues, the derivatives of the eigenvalues with respect to the frequency may be computed. The advantage of Newton's method is the fast quadratic convergence. However the computation of the derivative requires the matrices M, C, K from the FEM model, which leads to more complex program structure.

The analysis described above is employed for simulating the dynamical behavior of assemblies comprising frequency dependent materials. Both methods work very efficiently and save hundred of FEM-computation in comparison with the state of the art methods.

In all of the above it is assumed that a frequency dependant material is a polymer and a rubber. The plurality of variables characteristic for the frequency dependent materials comprises at least one of Young's modulus (E), Poisson's ratio and loss factor, where the plurality of variables for the frequency dependent materials have a matrix representation.

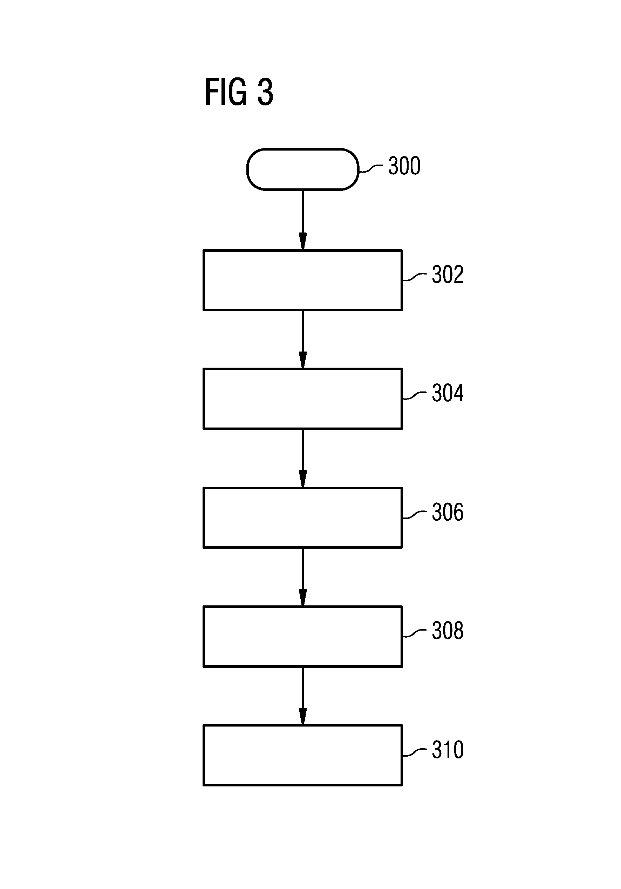

Referring now to Figure 3, Figure 3 is a representation of a flow chart of the method of the present invention.

The method of figure 3 comprises at least the step of importing a frequency dependence information, 302, regarding a plurality of variables characteristic for the frequency dependant material, the step of stating a characteristic relationship, 304, for the frequency where a system response has a peak value, a value of a frequency provided into the analysis apparatus being equal to a frequency where the system response has a peak, the step of solving 306, the characteristic relationship by applying an iteration sequence, and the step of obtaining 308 a plurality of frequency values that define the system response peaks for the frequency dependant material, while the response is 310 one of an amplitude of the oscillation, and stress.

The analysis method described in detail above in connection with FIG. 3 is used for and in the simulating the dynamical behavior of assemblies comprising frequency dependent materials.

The present invention is also directed to an analysis apparatus for studying the behavior of a system comprising frequency dependant materials. The analysis apparatus of the present invention, appropriate to be employed for performing simulation of the frequency dependant materials, comprises at least means for importing a frequency dependent information regarding a plurality of variables characteristic for the frequency dependant material, means for providing a characteristic relationship for the frequency where the system response has a peak value, wherein a value of a frequency provided into the analysis apparatus is equal to a frequency where the system response has a peak, means for solving the characteristic relationship by applying an iteration sequence, and means for obtaining a plurality of frequency values that define the system response peaks for the frequency dependant material, wherein the response is one of amplitude of the oscillation, stress or other response.

In the analysis apparatus of the present invention the means for storing the information are a memory, the means for stating a characteristic relationship for a peak value of a frequency are software storing and running means, and the means for solving the characteristic relationship by applying an iteration sequence are a processor. The means for obtaining a plurality of frequency values are envisioned to comprise among others display means. The above enumeration of means is exemplary and for the specific implementation of said means the person skilled in the art may envision alternative implementations.

The present invention is also directed to an analysis software means for a system comprising frequency dependent materials, software residing into the analysis apparatus. The software of the present invention enables the method of the present invention to import a frequency dependent information regarding a plurality of variables characteristic for the frequency dependant material, to provide a characteristic relationship for the frequency where a system response has a peak value, wherein the value of a frequency provided into the analysis apparatus is equal to a frequency where the system response has a peak, to solve the characteristic relationship by applying an iteration sequence, and to obtain a plurality of frequency values that define the system response peaks for the frequency dependant material, wherein the response is one of an amplitude of the oscillation, and stress.

The analysis method described in detail above in connection with FIG. 3 is used for and in the simulating the dynamical behavior of systems and assemblies comprising frequency dependent materials.

Although the present invention has been disclosed in the form of preferred embodiments and variations thereon, it will be understood that numerous additional modifications and variations could be made thereto without departing from the scope of the invention. For the sake of clarity, it is to be understood that the use of "a" or "an" through this application does not exclude a plurality, and "comprising: does not exclude other steps or elements. A " unit", or "module" can comprise a number of units or modules, unless otherwise stated.

## Claims

1. An analysis method for a system comprising frequency dependent materials, practiced by an analysis apparatus, comprising:

   importing a frequency dependent information regarding a plurality of variables characteristic for the frequency dependant material;
   providing a characteristic relationship for the frequency where a system response has a peak value,

   wherein a value of a frequency provided into said analysis apparatus is equal to a frequency where the system response has a peak,
   solving the characteristic relationship by applying an iteration sequence, and
   obtaining a plurality of frequency values that define said system response peaks for the frequency dependant material, wherein said response is one of an amplitude of the oscillation, stress or other.

2. The method of claim 1, wherein a frequency dependant material is one of a polymer and a rubber.

3. The method of claim 1, wherein said plurality of variables characteristic for the frequency dependent materials comprises at least one of Young's modulus (E), Poisson's ratio, and loss factor or damping coefficient.

4. The method of claim 3, wherein damping (C) and stiffness (K) have a matrix representation.

5. The method of claim 1, wherein said plurality of variables characteristic for the frequency dependant material are imported from commercially available tables, and databases listing materials properties.

6. The method of claim 1, wherein said peak value of the system response is defined by an eigenvalue with a real and an imaginary part, and wherein the eigenvalue is frequency dependent.

7. The method of claim 1, wherein said matrices C, and K are frequency dependent.

8. The method of claim 1, wherein said characteristic relationship for a system response peak value is

$$f_{(\omega)} = I_m(\lambda(\omega)) - 1/2\pi\omega = 0$$

9. The method of claim 1, wherein said iteration is one of a Gauss-Seidel iteration and a Newton's method.

10. The method of claim 1, wherein said method is employed for simulating the dynamical behavior of parts and assemblies containing frequency dependent materials.

11. An analysis apparatus for studying the behavior of a system comprising frequency dependant materials, comprising:

means for importing a frequency dependent information regarding a plurality of variables characteristic for the frequency dependant material;
means for providing a characteristic relationship for the frequency where the system response has a peak value,

wherein a value of a frequency provided into said analysis apparatus is equal to a frequency where the system response has a peak,
means for solving the characteristic relationship by applying an iteration sequence, and
means for obtaining a plurality of frequency values that define said system response peaks for the frequency dependant material,
wherein said response is one of amplitude of the oscillation, stress or other response.

12. The apparatus of claim 11, wherein said means for storing said information are a memory, and wherein said memory stores an iteration sequence.

13. The apparatus of claim 11, wherein said means for stating a characteristic relationship for a peak value of a frequency are software storing and running means.

14. The apparatus of claim 11, wherein said means for solving the characteristic relationship by applying an iteration sequence are a processor.

15. The apparatus of claim 11, wherein said means for obtaining a plurality of frequency values comprise among others display means, and wherein said display means display said data as one of a graph and a collection of values.

16. An analysis software means for a system comprising frequency dependent materials residing into an analysis apparatus, the software enabling:

importing a frequency dependent information regarding a plurality of variables characteristic for the frequency dependant material;
providing a characteristic relationship for the frequency where a system response has a peak value,

wherein a value of a frequency provided into said analysis apparatus is equal to a frequency where the system response has a peak,
solving the characteristic relationship by applying an iteration sequence, and
obtaining a plurality of frequency values that define said system response peaks for the frequency dependant material,
wherein said response is one of an amplitude of the oscillation, and stress.

**Amended claims in accordance with Rule 137(2) EPC.**

1. An analysis method for simulating the dynamical behavior of parts and assemblies containing frequency dependent materials in a system, comprising:

importing frequency dependent information regarding a plurality of variables characteristic for the parts and assemblies containing frequency dependant materials ;
stating a characteristic relationship for an eigenvalue of a frequency of said parts and assemblies containing frequency dependant materials,
wherein the characteristic relationship takes into account at least one of the plurality of variables characteristic for the frequency dependant material; and
wherein a value of an imported frequency employed for the computation of the at least one of the plurality of variable characteristics for the frequency dependant materials is equal to a peak frequency of the system; solving the characteristic relationship by applying an iteration sequence to obtain a plurality of frequency values that define said response peaks for the frequency dependant material,
wherein said at least one of the plurality of variable characteristics for the frequency dependant material is one of an amplitude of the oscillation, and stress , and
wherein said characteristic relationship is

$$f_{(\omega)} = I_m(\lambda(\omega)) \ - \ 1/2\pi\omega = 0$$

where $I_m(\lambda(\omega))$ is the imaginary part function of the eigenvalue of a frequency of said assembly, and $1/2\pi\omega$ is the input frequency for the frequency dependent material properties.

2. The method of claim 1, wherein a frequency dependant material is one of a polymer and a rubber.

3. The method of claim 1, wherein said plurality of variables characteristic for the frequency dependent materials comprises at least one of Young's modulus (E), Poisson's ratio, and loss factor or damping coefficient.

4. The method of claim 3, wherein damping (C) and stiffness (K) have a matrix representation.

5. The method of claim 1, wherein said plurality of variables characteristic for the frequency dependant material are imported from commercially available tables, and databases listing materials properties.

6. The method of claim 1, wherein said peak value of the system response is defined by an eigenvalue with a real and an imaginary part, and wherein the eigenvalue is frequency dependent.

7. The method of claim 4, wherein said damping matrix (C) and said stiffness matrix (K) are frequency dependent.

8. The method of claim 1, wherein said iteration is one of a Gauss-Seidel iteration and a Newton's method.

9. An analysis apparatus for simulating the dynamical behavior of parts and assemblies containing frequency dependent materials in a system, comprising:

   means for importing frequency dependent information regarding a plurality of variables characteristic for the parts and assemblies containing frequency dependent materials ;
   means for stating a characteristic relationship for an eigenvalue of a frequency of said parts and assemblies containing frequency dependant materials,
   wherein the characteristic relationship takes into account at least one of the plurality of variables characteristic for the frequency dependant material, and
   wherein a value of an imported frequency employed for the computation of the at least one of the plurality of variable characteristics for the frequency dependant materials is equal to a peak frequency of the system;
   means for solving the characteristic relationship by applying an iteration sequence to obtain a plurality of frequency values that define said response peak for the frequency dependant material,
   wherein said at least one of the plurality of variable characteristics for the frequency dependant material is one of an amplitude of the oscillation, and stress, and
   wherein said characteristic relationship is

$$f_{(\omega)} = I_m(\lambda(\omega)) \ - \ 1/2\pi\omega = 0$$

where $I_m(\lambda(\omega))$ is the imaginary part function of the eigenvalue of a frequency of said assembly, and $1/2\pi\omega$ is the input frequency for the frequency dependent material properties.

**10.** The apparatus of claim 9, wherein said means for storing said information are a memory, and wherein said memory stores an iteration sequence.

**11.** The apparatus of claim 9, wherein said means for stating a characteristic relationship for a peak value of a frequency are software storing and running means.

**12.** The apparatus of claim 9, wherein said means for solving the characteristic relationship by applying an iteration sequence are a processor.

**13.** The apparatus of claim 9, wherein said means for obtaining a plurality of frequency values comprise display means, and wherein said display means display said data as one of a graph and a collection of values.

**14.** An analysis software means for simulating the dynamical behavior of parts and assemblies containing frequency dependent materials in a system, the software enabling:

importing frequency dependent information regarding a plurality of variables characteristic for the parts and assemblies containing frequency dependant materials ;
stating a characteristic relationship for an eigenvalue of a frequency of said parts and assemblies containing frequency dependant materials,
wherein the characteristic relationship takes into account at least one of the plurality of variables characteristic for the frequency dependant material; and
wherein a value of an imported frequency employed for the computation of the at least one of the plurality of variable characteristics for the frequency dependant materials is equal to a peak frequency of the system;
solving the characteristic relationship by applying an iteration sequence to obtain a plurality of frequency values that define said response peaks for the frequency dependant material,
wherein said at least one of the plurality of variable characteristics for the frequency dependant material is one of an amplitude of the oscillation, and stress , and
wherein said characteristic relationship is

$$f_{(\omega)} = I_m(\lambda(\omega)) \ - \ 1/2\pi\omega = 0$$

where $I_m(\lambda(\omega))$ is the imaginary part function of the eigenvalue of a frequency of said assembly, and $1/2\pi\omega$ is the input frequency for the frequency dependent material properties.

## FIG 1

## FIG 2

# FIG 3

Europäisches
Patentamt

European
Patent Office

Office européen
des brevets

# EUROPEAN SEARCH REPORT

**Application Number**

EP 10 17 8381

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | M.I. Friswell, D.J. Inman: "FINITE ELEMENT MODELS WITH VISCOELASTIC DAMPING", 17th International Modal Analysis Conference, Orlando, Florida, USA, February 1999,, 28 February 1999 (1999-02-28), pages 181-187, XP002613310, Retrieved from the Internet: URL:http://michael.friswell.com/PDF_Files/C95.pdf [retrieved on 2010-12-08] * the whole document, in particular sections 2 and 3 * | 1-16 | INV. G06F17/50 |
| A | MACCHETTA A ET AL: "Processing of viscoelastic data for engineering design with polymers", MATERIALS AND DESIGN, LONDON, GB, vol. 10, no. 6, 1 November 1989 (1989-11-01), pages 293-296, XP027277080, ISSN: 0261-3069 [retrieved on 1989-11-01] * the whole document * | 1-16 | |
| | | | **TECHNICAL FIELDS SEARCHED (IPC)** |
| | | | G06F |

The present search report has been drawn up for all claims

| Place of search | Date of completion of the search | Examiner |
|---|---|---|
| Munich | 13 December 2010 | Lerbinger, Klaus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)